(19) Europäisches Patentamt
European Patent Office
Office européen des brevets

(11) **EP 1 786 030 A1**

(12) **EUROPEAN PATENT APPLICATION**
published in accordance with Art. 158(3) EPC

(43) Date of publication:
**16.05.2007 Bulletin 2007/20**

(51) Int Cl.:
*H01L 21/316* (2006.01)

(21) Application number: **05781277.8**

(22) Date of filing: **30.08.2005**

(86) International application number:
**PCT/JP2005/015727**

(87) International publication number:
**WO 2006/025363 (09.03.2006 Gazette 2006/10)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **31.08.2004 JP 2004253530**

(71) Applicant: **TOKYO ELECTRON LIMITED**
**Minato-ku,**
**Tokyo 107-8481 (JP)**

(72) Inventors:
• **KOBAYASHI, Takashi,**
**c/o TOKYO ELECTRON AT LIMITED**
**Amagasaki-shi,**
**Hyogo 660-0891 (JP)**
• **KITAGAWA, Junichi,**
**c/o TOKYO ELECTRON AT LIMITED**
**Amagasaki-shi,**
**Hyogo 660-0891 (JP)**

(74) Representative: **HOFFMANN EITLE**
**Patent- und Rechtsanwälte**
**Arabellastrasse 4**
**81925 München (DE)**

(54) **SILICON OXIDE FILM FORMING METHOD, SEMICONDUCTOR DEVICE MANUFACTURING METHOD AND COMPUTER STORAGE MEDIUM**

(57) A plasma processing apparatus 100 of the RLSA type includes a planar antenna with a plurality of slots formed therein, by which microwaves are supplied into a process chamber to generate plasma. In this apparatus, poly-silicon oxidation is performed at a pressure of 67 to 667 Pa inside the chamber, a temperature of 300 to 600°C, and a microwave power of 1,000 to 3,500W, while a process gas containing Ar gas at a rate of 100 to 2,000 mL/min and $O_2$ gas at a rate of 1 to 500 mL/min is used with $O_2$ gas/Ar gas ratio set to be 0.5 to 5%.

FIG.1

EP 1 786 030 A1

**Description**

Technical Field

The present invention relates to a method for forming an oxide film in manufacturing a semiconductor device, such as a flash memory device or thin film transistor, and a method for manufacturing a semiconductor device.

Background Art

In the process of manufacturing various semiconductor devices, such as flash memory devices of silicon semiconductor and thin film transistors used in LCDs (Liquid Crystal Display), an oxide film is formed to insulate a gate electrode. In general, an oxide film of this type is formed by a thermal oxidation method or CVD method. A thermal oxide film formed by thermally oxidizing silicon or poly-silicon (polycrystalline silicon) is higher in film quality, as compared to films formed by other methods. As a consequence, conventionally, thermal oxidation methods of the dry $O_2$ type and of the wet type, such as the WVG (Water Vapor Generation) type and ISSG (In Situ Steam Generation) type, are widely used.
However, a thermal oxidation method is arranged to perform an oxidation process while heating poly-silicon to a high temperature of 900 to 1,000°C within an oxidation atmosphere. Consequently, an impurity contained in the poly-silicon as a dopant, such as phosphorous, may be re-diffused and segregated, and/or the poly-silicon may re-crystallized, thereby damaging flatness of the interface between the poly-silicon and oxide film. Further, where a thermal oxidation method is arranged to form an oxide film by use of an oxidation atmosphere with hydrogen added therein, hydrogen separates from the oxide film and forms hole traps in the film during the process. As a result, problems arise such that the breakdown property and reliability of the oxide film are deteriorated.
On the other hand, as an example of an oxide film forming method other than the thermal oxidation method and CVD method, there is proposed a technique for forming an oxide film by use of high density microwave plasma at a low temperature around 400°C (for example, Patent Document 1 and Patent Document 2). According to the methods disclosed in Patent Documents 1 and 2, it is expected by use of a low temperature plasma process to attain an oxide film with electric properties and reliability comparable to thermal oxide films.

[Patent Document 1] WO 01/69665 (FIG. 2 etc.)

[Patent Document 2] WO 01/69673 (FIG. 2 etc.)

Disclosure of Invention

It is important to form an oxide film on poly-silicon to have a desired film thickness in a short time. An increase in the formation rate (oxidation rate) of the oxide film contributes to an increase in the throughput of the entire manufacturing process of semiconductor devices. However, the methods disclosed in Patent Documents 1 and 2 are mainly conceived to improve the quality of an oxide film, and they are not directed to study about conditions for improving the oxidation rate thereof.
Accordingly, an object of the present invention is to provide an oxide film forming method for forming an oxide film of high quality at a high oxidation rate on poly-silicon.
The present inventors made assiduous studies, and, as a result, the inventors have arrived at the findings given below. Specifically, in an oxidation process by use of a plasma processing apparatus of the RLSA type, the oxidation rate is influenced to a large extent by gas components selected for the process gas and the oxygen ratio in the process gas. However, if the oxygen ratio is simply set larger, the oxidation rate may be adversely decreased. In other words, where poly-silicon oxidation is performed by use of a plasma processing apparatus of the RLSA type, in order to attain both of a high oxidation rate and high film quality, the plasma process conditions need to be controlled. The present invention has been achieved on the basis of the findings given above.
Specifically, according to a first aspect of the present invention, there is provided an oxide film forming method for a semiconductor device, which includes at least a poly-silicon layer and an oxide film formed on the poly-silicon layer, the method comprising:

subjecting the poly-silicon layer to a plasma process by use of a process gas containing a rare gas and oxygen gas with a ratio of the oxygen gas relative to the rare gas set to be 0.5 to 5%, thereby forming an oxide film on the poly-silicon layer, within a plasma processing apparatus including a planar antenna with a plurality of slots formed therein, by which microwaves are supplied into a process chamber to generate plasma.

In the oxide film forming method according to the first aspect, the plasma process is preferably performed at a pressure of 67 to 667 Pa and a process temperature of 300 to 600°C. Further, the process chamber is preferably set to have an oxygen partial pressure of 0.66 to 2.66 Pa therein.

According to a second aspect of the present invention, there is provided a semiconductor device manufacturing method comprising:

forming an insulating film on a substrate;
forming a first poly-silicon layer on the insulating film;
subjecting the first poly-silicon layer to a plasma process by use of a process gas containing a rare gas and oxygen gas with a ratio of the oxygen gas relative to the rare gas set to be 0.5 to 5%, thereby forming an oxide film on the first poly-silicon layer, within a plasma processing apparatus including a planar antenna with a plurality of slots formed therein, by which microwaves are supplied into a process chamber to generate plasma; and
forming a second poly-silicon layer on or above the oxide film.

In the semiconductor device manufacturing method according to the second aspect, the process chamber is preferably set to have an oxygen partial pressure of 0.66 to 2.66 Pa therein. Further, the semiconductor device preferably comprises a flash memory device or a thin film transistor.

According to a third aspect of the present invention, there is provided an oxide film forming method for a semiconductor device, which includes at least a poly-silicon layer and an oxide film formed on the poly-silicon layer, the method comprising:

a first oxidation step arranged to subject the poly-silicon layer to a plasma process by use of a process gas containing a rare gas and oxygen gas with a ratio of the oxygen gas relative to the rare gas set to be 0.5 to 5%, thereby forming an oxide film on the poly-silicon layer, within a plasma processing apparatus including a planar antenna with a plurality of slots formed therein, by which microwaves are supplied into a process chamber to generate plasma; and
a second oxidation step arranged to subject the oxide film formed by the first oxidation step to a thermal oxidation process.

In the third aspect, the process chamber is preferably set to have an oxygen partial pressure of 0.66 to 2.66 Pa therein.

According to a fourth aspect of the present invention, there is provided a control program for execution on a computer, used for a plasma processing apparatus including a planar antenna with a plurality of slots formed therein, by which microwaves are supplied into a process chamber to generate plasma, wherein the control program, when executed by the computer, controls the apparatus to subject a poly-silicon layer to a plasma process by use of a process gas containing a rare gas and oxygen gas with a ratio of the oxygen gas relative to the rare gas set to be 0.5 to 5%, thereby forming an oxide film on the poly-silicon layer,

According to a fifth aspect of the present invention, there is provided a computer storage medium that stores a control program for execution on a computer, used for a plasma processing apparatus including a planar antenna with a plurality of slots formed therein, by which microwaves are supplied into a process chamber to generate plasma, wherein the control program, when executed by the computer, controls the apparatus to subject a poly-silicon layer to a plasma process by use of a process gas containing a rare gas and oxygen gas with a ratio of the oxygen gas relative to the rare gas set to be 0.5 to 5%, thereby forming an oxide film on the poly-silicon layer,

According to a sixth aspect of the present invention, there is provided a plasma processing apparatus comprising:

a process chamber configured to be vacuum-exhausted and to process a target object by plasma;
a plasma supply source including a planar antenna with a plurality of slots formed therein, by which microwaves are supplied into the process chamber to generate plasma; and
a control section that exercises control to subject a poly-silicon layer to a plasma process by use of a process gas containing a rare gas and oxygen gas with a ratio of the oxygen gas relative to the rare gas set to be 0.5 to 5%, thereby forming an oxide film on the poly-silicon layer within the process chamber.

According to the present invention, where poly-silicon oxidation is performed in a plasma processing apparatus of the RLSA type, the oxygen partial pressure is controlled to form an oxide film of high quality while maintaining a high oxidation rate.

Specifically, the plasma processing apparatus of the RLSA type provides plasma with a lower electron temperature as compared to other high density plasma, and thus can form an oxide film of high quality at a low temperature in a short time.

In the case of radical oxidation using high density plasma of the RLSA type, since the energy of radicals is high, plane direction dependence does not appear. Further, according to this method, since poly-silicon oxidation is performed by a low temperature process, poly-silicon re-crystallization is suppressed so that the poly-silicon surface can maintain the flatness with no protrusions formed thereon. Accordingly, this method is far more advantageous, as compared to thermal oxidation processes that have plane direction dependence in the initial stage of oxidation.

Further, since an oxide film is formed at a low temperature, re-diffusion of an impurity in the poly-silicon is hardly caused, and thus the concentration of the impurity taken into the oxide film becomes low. Consequently, the oxide film can be formed to have high quality with few energy levels due to the impurity in the film.

Brief Description of Drawings

[FIG. 1] This is a sectional view schematically showing an example of a plasma processing apparatus suitable for performing a method according to the present invention.

[FIG. 2] This is a view showing the structure of a planar antenna member.

[FIG. 3A] This is a view showing a state where a LOCOS oxide film is formed on a silicon substrate, in the process of manufacturing a flash memory device.

[FIG. 3B] This is a view showing a state where a first poly-silicon layer is formed to cover a tunnel oxide film, in the process of manufacturing the flash memory device.

[FIG. 3C] This is a view showing a state where an insulating film having an ONO multi-layered structure is formed to have a predetermined thickness, in the process of manufacturing the flash memory device.

[FIG. 3D] This is a view showing a state where a flash memory device 200 is formed, in the process of manufacturing the flash memory device.

[FIG. 4] This is a graph showing the relationship between the ratio of $O_2$ gas relative to Ar gas used in a plasma process and the film thickness and surface uniformity.

[FIG. 5A] This is a view showing a step in manufacturing a test gate electrode.

[FIG. 5B] This is a view showing a step in manufacturing the test gate electrode.

[FIG. 5C] This is a view showing a step in manufacturing the test gate electrode.

[FIG. 5D] This is a view showing a step in manufacturing the test gate electrode.

[FIG. 5E] This is a view showing a step in manufacturing the test gate electrode.

[FIG. 5F] This is a view showing a step in manufacturing the test gate electrode.

[FIG. 5G] This is a view showing a step in manufacturing the test gate electrode.

[FIG. 5H] This is a view showing a step in manufacturing the test gate electrode.

[FIG. 5I] This is a view showing a step in manufacturing the test gate electrode.

[FIG. 6] This is a graph showing the surface roughness of first poly-silicon layers.

[FIG. 7A] This is a view showing an AFM measurement picture image of a surface of a first poly-silicon layer formed by a plasma process according to the present invention.

[FIG. 7B] This is a view showing an AFM measurement picture image of a surface of a first polysilicon layer formed by a HTO-CVD process.

[FIG. 7C] This is a view showing an AFM measurement picture image of a surface of a first poly-silicon layer formed by a dry thermal oxidation process.

[FIG. 8A] This is a view showing a TEM picture image of a cross-section of a poly-silicon layer before oxide film formation.

[FIG. 8B] This is a view showing a TEM picture image of a cross-section of a poly-silicon layer after a plasma oxidation process.

[FIG. 8C] This is a view showing a TEM picture image of a cross-section of a poly-silicon layer after a thermal oxidation process.

[FIG. 9] This is a graph showing P concentration distribution in the depth direction of a poly-silicon layer with an oxide film formed thereon.

[FIG. 10] This is a graph showing B concentration distribution in the depth direction of a poly-silicon layer with an oxide film formed thereon.

[FIG. 11A] This is a view showing a TEM picture image that represents a P segregation state of a poly-silicon layer with an oxide film formed thereon.

[FIG. 11B] This is a view showing a TEM picture image that represents a P segregation state of a poly-silicon layer with an oxide film formed thereon.

[FIG. 11C] This is a view showing an EELS picture image that represents a P segregation state of a poly-silicon layer with an oxide film formed thereon.

[FIG. 11D] This is a view showing an EELS picture image that represents a P segregation state of a poly-silicon layer with an oxide film formed thereon.

[FIG. 12] This is a graph showing J-E plots concerning gate oxide films.

[FIG. 13] This is a graph showing the relationship between Eox and Tox concerning gate oxide films.

[FIG. 14] This is a graph showing a J-E plot concerning an oxide film formed by use of a process gas without hydrogen added therein.

[FIG. 15] This is a graph showing a J-E plot concerning an oxide film formed by use of a process gas with hydrogen added therein.

[FIG. 16] This is a view schematically showing a thin film transistor to which the present invention is applicable.

Best Mode for Carrying Out the Invention

A preferable embodiment of the present invention will now be described with reference to the accompanying drawings.

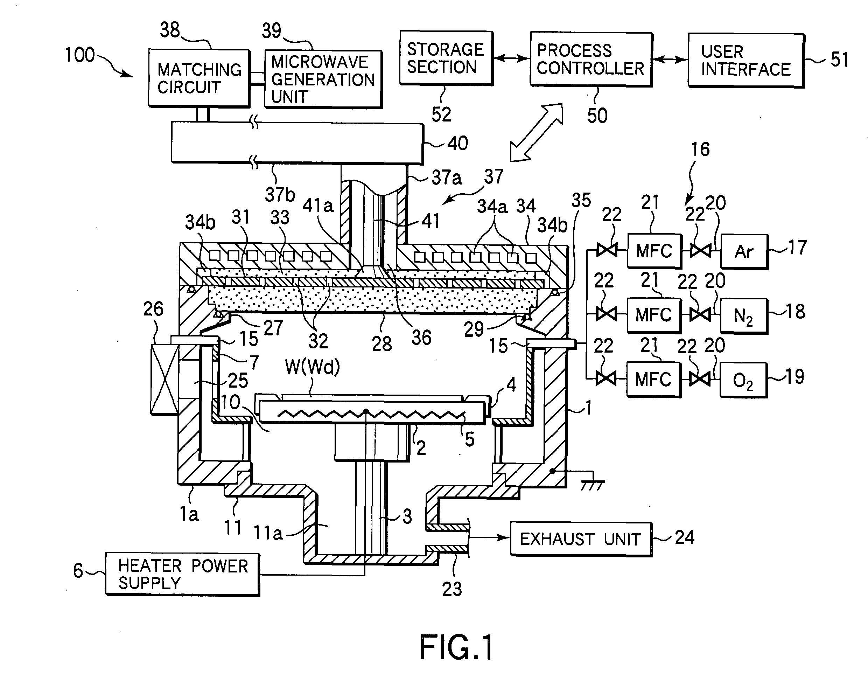

FIG. 1 is a sectional view schematically showing an example of a plasma processing apparatus suitable for performing a plasma oxidation method according to the present invention. This plasma processing apparatus utilizes an RLSA (Radial Line Slot Antenna) plasma generation technique, in which microwaves are supplied from a planar antenna having a plurality of slots into a process chamber to generate plasma, so that microwave plasma is generated with a high density and a low electron temperature.

This plasma processing apparatus 100 can utilize plasma having a low electron temperature to proceed with a plasma process at a low temperature of 600°C or less and free from damage to the underlying film and so forth, and can also provide good plasma uniformity. Consequently, this apparatus can realize a dense oxide film and process uniformity comparable to those attained by diffusion furnaces. Accordingly, the plasma oxidation processing apparatus 100 suits for oxide film formation on a poly-silicon layer.

This plasma processing apparatus 100 includes an airtight chamber 1, which is essentially circular and cylindrical, and is grounded. The shape of the chamber 1 is not limited to a circular cylinder, and it may be a rectangular shape. The bottom wall 1a of the chamber 1 has a circular opening 10 formed essentially at the center, and is provided with an exhaust chamber 11 communicating with the opening 10 and extending downward.

The chamber 1 is provided with a susceptor 2 located therein and made of a ceramic, such as AlN, for supporting a target substrate, such as a wafer W, in a horizontal state. The susceptor 2 is supported by a cylindrical support member 3 made of a ceramic, such as AlN, and extending upward from the center of the bottom of the exhaust chamber 11. The susceptor 2 is provided with a guide ring 4 located on the outer edge to guide the wafer W. The susceptor 2 is further provided with a heater 5 of the resistance heating type built therein. The heater 5 is supplied with a power from a heater power supply 6 to heat the susceptor 2, thereby heating the target object or wafer W. For example, the heater 5 can control the temperature within a range of from room temperature to 800°C. A cylindrical liner 7 made of quartz is attached along the inner wall of the chamber 1.

The susceptor 2 is provided with wafer support pins (not shown) that can project and retreat relative to the surface of the susceptor 2 to support the wafer W and move it up and down.

A gas feed member 15 having an annular structure is attached in the sidewall of the chamber 1, and is connected to a gas supply system 16. The gas feed member may have a shower structure. The gas supply system 16 includes an Ar gas supply source 17, an $N_2$ gas supply source 18, and an $O_2$ gas supply source 19, from which gases are supplied through respective gas lines 20 to the gas feed member 15 and are delivered from the gas feed member 15 into the chamber 1. Each of the gas lines 20 is provided with a mass-flow controller 21 and two switching valves 22 one on either side of the controller 21. In the plasma processing apparatus 100 shown in FIG. 1, $N_2$ gas is used together with Ar gas to form a nitride film and to subject an oxide film to a nitridation process. $O_2$ gas is used together with Ar gas to form an oxide film. However, the gases used here are not limited to these kinds, and, for example, gas supply sources of $NH_3$ gas, NO gas, $N_2O$ gas, and halogen family cleaning gas may be connected.

The sidewall of the exhaust chamber 11 is connected to an exhaust unit 24 including a high speed vacuum pump through an exhaust line 23. The exhaust unit 24 can be operated to uniformly exhaust the gas from inside the chamber 1 into the space 11a of the exhaust chamber 11, and then out of the exhaust chamber 11 through the exhaust line 23. Consequently, the inner pressure of the chamber 1 can be decreased at a high speed to a predetermined vacuum level, such as 0.133 Pa.

The chamber 1 has a transfer port 25 formed in the sidewall and provided with a gate valve 26 for opening/closing the transfer port 25. The wafer W is transferred between the plasma processing apparatus 100 and an adjacent transfer chamber (not shown) through the transfer port 25.

The top of the chamber 1 is opened and is provided with an annular support portion 27 along the periphery of the opening. A microwave transmission plate 28 is airtightly mounted on the support portion 27 through a seal member 29. The microwave transmission plate 28 is made of a dielectric material, such as quartz or a ceramic, e.g., $Al_2O_3$, to transmit microwaves. The interior of the chamber 1 is thus held airtight.

A circular planar antenna member 31 is located above the microwave transmission plate 28 to face the susceptor 2. The planar antenna member 31 is mounted on the microwave transmission plate 28, and a retardation material 33 is further disposed to cover the top of the planar antenna member 31. The planar antenna member 31 and retardation material 33 are fixed at the periphery by a holding member 34b. A conductive shield lid 34 is disposed to cover the retardation material 33, and is supported on the upper end of the sidewall of the chamber 1. The planar antenna member 31 is a circular plate (or rectangular plate) made of a conductive material, and is formed to have, e.g., a diameter of 300 to 400 mm and a thickness of 1 to several mm (for example, 5 mm) for 8-inch wafers W. Specifically, the planar antenna member 31 is formed of, e.g., a copper plate or aluminum plate with the surface plated with gold. The planar antenna member 31 has a number of microwave radiation holes 32 penetrating therethrough and formed in a predetermined pattern.

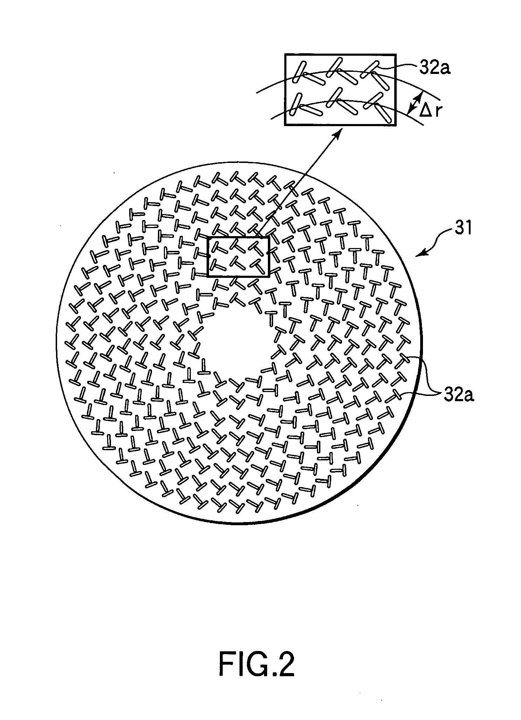

For example, as shown in FIG. 2, the microwave radiation holes 32 are formed of long grooves or slots 32a, wherein the slots 32a may be arranged such that adjacent slots 32a intersect with each other to form a T-shape, and they are arrayed concentrically. The length and array intervals of the slots 32a are determined in accordance with the wavelength of radio frequency generated by a microwave generation unit 39. The microwave radiation holes 32 (slots 32a) may have another shape, such as through holes of a circular shape. The array pattern of the microwave radiation holes 32 (slots 32a) is not limited to a specific one, and, for example, it may be spiral or radial other than concentric.

The retardation material 33 is made of a dielectric material with a dielectric constant larger than that of vacuum, and is located on the top of the planar antenna member 31. The planar antenna member 31 and retardation material 33 are covered with the shield lid 34 located at the top of the chamber 1 and made of a metal material, such as aluminum, stainless steel, or copper. A seal member 35 is interposed between the top of the chamber 1 and the shield lid 34 to seal this portion. The shield lid 34 is provided with a plurality of cooling water passages 34a formed therein. A cooling water is supplied to flow through the cooling water passages and thereby cool the planar antenna member 31, microwave transmission plate 28, retardation material 33, and shield lid 34. Consequently, these members are prevented from being damaged by the heat of plasma, while plasma is stably maintained. The shield lid 34 is grounded.

The shield lid 34 has an opening 36 formed at the center of the upper wall and connected to a wave guide tube 37. The wave guide tube 37 is connected to a microwave generation unit 39 at one end through a matching circuit 38. The microwave generation unit 39 generates microwaves with a frequency of, e.g., 2.45 GHz, which are transmitted through the wave guide tube 37 to the planar antenna member 31. The microwaves may have a frequency of 8.35 GHz or 1.98 GHz.

The wave guide tube 37 includes a coaxial wave guide tube 37a having a circular cross-section and extending upward from the opening 36 of the shield lid 34, and a rectangular wave guide tube 37b connected to the upper end of the coaxial wave guide tube 37a and extending in a horizontal direction. The rectangular wave guide tube 37b includes a mode transducer 40 at the end connected to the coaxial wave guide tube 37a. The coaxial wave guide tube 37a includes an inner conductor 41 extending at the center A flared portion 41a is formed at the lower end portion of the inner conductor 41. The inner conductor is connected and fixed to the center of the planar antenna member 31 at the lower end through the flared portion 41a. The flared portion 41a of the inner conductor 41 has a shape that increases its diameter toward the planar antenna member 31 to uniformly and efficiently propagate microwaves in the horizontal direction. Consequently, microwaves are efficiently propagated through the inner conductor 41 of the coaxial wave guide tube 37a and flared portion 41a of the inner conductor 41 to the planar antenna member 31.

The respective components of the plasma processing apparatus 100 are connected to and controlled by a process controller 50 comprising a CPU. The process controller 50 is connected to a user interface 51 including, e.g. a keyboard and a display, wherein the keyboard is used for a process operator to input commands for operating the plasma processing apparatus 100, and the display is used for showing visualized images of the operational status of the plasma processing apparatus 100.

Further, the process controller 50 is connected to a storage section 52 that stores recipes containing control programs, process condition data, and so forth recorded therein, for the process controller 50 to control the plasma processing apparatus 100 so as to perform various processes.

A required recipe is retrieved from the storage section 52 and executed by the process controller 50 in accordance with an instruction or the like input through the user interface 51. Consequently, the plasma processing apparatus 100 can perform a predetermined process under the control of the process controller 50. The recipes containing control programs and process condition data may be used while they are stored in a computer readable storage medium, such as a CD-ROM, hard disk, flexible disk, or flash memory. Alternatively, the recipes may be used online while they are transmitted from another apparatus through, e.g., a dedicated line, as needed.

In the plasma processing apparatus of the RLSA type 100 arranged as described above, a plasma oxidation process of poly-silicon is performed under conditions including gas flow rates preferably set such that a rare gas such as Ar gas: 100 to 3,000 mL/min and $O_2$ gas: 0.5 to 500 mL/min, and more preferably a rare gas: 100 to 2,000 mL/min and $O_2$ gas: 0.5 to 52 mL/min.

In order to increase the oxidation rate, the process gas is preferably set to have an $O_2$ ratio of 0.5 to 2.5% and more preferably of 1 to 2%. Further, the pressure inside the chamber is preferably set to be 67 to 667 Pa. The temperature is preferably set to be 400 to 600°C. The microwave power is preferably set to be 2,000 to 3,500W. The plasma process time is preferably set to be 5 to 600 seconds and more preferably to be 10 to 180 seconds. The thickness of an oxide film to be formed is preferably set to be 1 to 12 nm and more preferably to be 2.2 to 5 nm, as required by the purpose. With the conditions described above, it is possible to form a dense oxide film of high quality at a high oxidation rate on a poly-silicon surface.

More specifically, for example, a poly-silicon oxidation process is performed in the plasma processing apparatus 100 by the following steps 1 to 7.

Step 1: Seasoning

At first, before a wafer W to be processed is loaded into the chamber 1, seasoning is performed to remove residual hydrogen inside the chamber 1. This process is performed to prepare the atmosphere inside the chamber 1, because, if $H_2$ is present even in about 0.2% inside the chamber 1, it affects the oxide film formation and deteriorates the process yield. The seasoning is performed under the same conditions as those used for a plasma process describe later. The seasoning is performed preferably for 160 to 600 seconds, such as about 360 seconds. The seasoning may be performed by use of a dummy wafer (Wd), every time one wafer W is processed.

Step 2: Wafer loading

After the seasoning of Step 1 is finished, the gate valve 26 is opened, and a wafer W to be processed having poly-silicon (gate electrode) formed thereon is transferred through the transfer port 25 into the chamber 1 and placed on the susceptor 2.

Step 3: Temperature increase/Pressure increase

Ar gas and $O_2$ gas are supplied at predetermined flow rates from the Ar gas supply source 17 and $O_2$ gas supply source 19 in the gas supply system 16 through the gas feed member 15 into the chamber 1, and the pressure inside the chamber 1 is maintained at a predetermined value. Specifically, for example, Ar gas is set at a large flow rate of 1,500 mL/min and $O_2$ gas is set at a flow rate of 5 mL/min, so that the pressure is increased to a high value of 533.3 Pa. Further, the temperature of the wafer W is increased to about 500°C. As described above, the gases are supplied into the chamber 1 to set the pressure to be higher than that of the process, and the temperature is increased. Consequently, the heat conductivity is enhanced by the gas to facilitate an increase in the temperature of the wafer W.

Step 4: Flow rate control

While the heating temperature and pressure set in Step 3 are maintained, Ar gas is set at a flow rate of 495 mL/min and $O_2$ gas is set at a flow rate of 5 mL/min, so that the total flow rate of the process gas is set at 500 mL/min (sccm) and is stabilized. The gas flow rate control may be performed together with process pressure control in Step 5 describe later.

Step 5: Process pressure control

While the gas flow rates set in step 4 are maintained, the pressure inside the chamber 1 is decreased to a process pressure of, e.g., about 133.3 Pa, and the partial pressure of $O_2$ gas is stabilized.

Step 6: Plasma process

Microwaves are supplied from the microwave generation unit 39 through the matching circuit 38 into the wave guide tube 37. The microwaves are supplied through the rectangular wave guide tube 37b, mode transducer 40, and coaxial wave guide tube 37a in this order, and specifically through the inner conductor 41 and the flared portion 41a thereof radially to the planar antenna member 31. Then, the microwaves are uniformly radiated from the planar antenna member 31 through the microwave transmission plate 28 into the space above the wafer W within the chamber 1. The microwaves are propagated in a TE mode through the rectangular wave guide tube 37b, and are then transduced from the TE mode into a TEM mode by the mode transducer 40 and propagated in the TEM mode through the coaxial wave guide tube 37a to the planar antenna member 31. When the microwaves are radiated from the planar antenna member 31 through the microwave transmission plate 28 into the chamber 1, an electromagnetic field is thereby formed inside the chamber 1. Consequently, Ar gas and $O_2$ gas are turned into plasma, by which the poly-silicon formed on the wafer W is oxidized. Since microwaves are radiated from a number of slots 32a of the planar antenna member 31, this microwave plasma has a high plasma density of about $5 \times 10^{11}$ to $1 \times 10^{13}$ /cm$^3$ or more, an electron temperature of about 0.7 to 2 eV, and a plasma density uniformity of $\pm 5\%$ or less. Accordingly, this plasma has merits such that a thin oxide film can be formed by an oxidation process at a low temperature and in a short time, while this plasma with a low electron temperature allows the underlying film to suffer less plasma damage due to ions and so forth, so an oxide film of high quality can be formed.

Step 7: Process end

After the oxide film formation on the wafer W is finished, plasma is terminated while the pressure and gas flow rates are maintained. Then, the gases are stopped, and gas inside the chamber 1 is exhausted by the exhaust unit 24, to decrease the pressure therein to atmospheric pressure.

According to the present invention, a method for forming an oxide film can utilize the plasma oxidation process exemplified by Steps 1 to 7 described above to form an oxide film of high quality. However, another preferable method may be arranged to first perform a plasma process for oxide film formation, and then further perform a thermal oxidation process at a temperature of about 900 to 1,200°C.

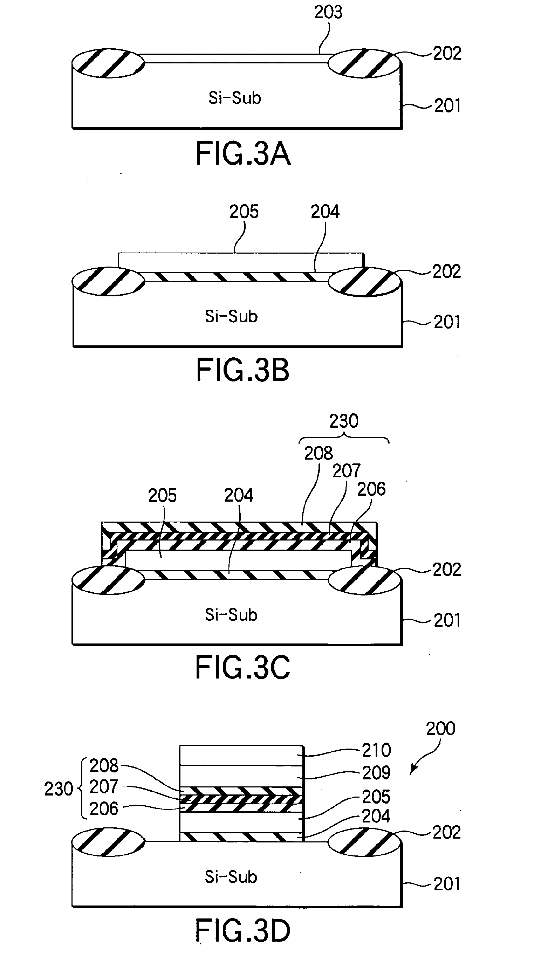

Next, an explanation will be given of steps in manufacturing a semiconductor device by use of a method according to the present invention, while taking as an example a flash memory device for constituting semiconductor integrated circuits. FIGS. 3A to 3D are views schematically showing steps in manufacturing a flash memory device 200.

At first, as shown in FIG. 3A, a LOCOS oxide film 202 is formed on a highly cleaned silicon substrate 201. At this time, the silicon substrate 201 has an oxide film 203 formed thereon.

Then, as shown in FIG. 3B, the part of the oxide film 203 within a memory cell region surrounded by the LOCOS oxide film 202 is removed. Then, a tunnel oxide film 204 is formed here to have a predetermined film thickness. The plasma processing apparatus 100 shown in FIG. 1 may be used to form the tunnel oxide film 204. After the tunnel oxide film 204 is formed, a first poly-silicon layer 205 is formed to cover the tunnel oxide film 204.

Then, as shown in FIG. 3C, a first silicon oxide film 206, a nitride film 207, and a second silicon oxide film 208 are formed in this order. Consequently, an insulating film having an ONO multi-layered structure with a predetermined thickness is formed of these films.

Specifically, in the plasma processing apparatus 100 shown in FIG. 1, the interior of the chamber 1 is exhausted to a high vacuum level, and Ar gas and $O_2$ gas are supplied through the gas feed member 15. The pressure inside the process chamber is set at 133 Pa and the temperature of the wafer W is set at 500°C. In this state, microwaves set at a microwave power of 2.750W are supplied through the planar antenna member 31 and microwave transmission plate 28 to generate high density plasma. By use of this high density plasma, the first silicon oxide film 206 is formed by oxidation on the first poly-silicon layer 205, until the film thickness reaches a value of about 1 to 12 nm, and preferably of 2.2 to 5 nm. In this plasma oxidation process, the gas flow rates are preferably set to make an oxygen ratio of 0.5 to 2.5%. For example, the gas flow rates are preferably set such that Ar gas: 100 to 2,000 mL/min and $O_2$ gas: 0.5 to 52 mL/min.

Then, after supply of microwaves is stopped, supply of Ar gas and $O_2$ gas is stopped and the interior of the chamber 1 is exhausted. After this silicon oxide film formation is finished, the wafer W is unloaded from the chamber 1.

Then, the SiN film is formed by CVD.

Specifically, in a thermal CVD apparatus, the silicon nitride film ($Si_3N_4$) 207 is formed on the first silicon oxide film 206 by use of, e.g., $SiH_2Cl_2$ gas and $NH_3$ gas at a film formation temperature of 750°C, until the film thickness reaches a value of about 5 to 7 nm.

Then, the second silicon oxide film 208 is formed by a thermal CVD method or high density plasma processing method.

For example, in the case of a thermal CVD method, the second silicon oxide film 208 is formed on the silicon nitride film ($Si_3N_4$) 207 by use of $SiH_2Cl_2$ gas (or $SiH_4$ gas) and $N_2O$ gas at 800°C, until the film thickness reaches a value of about 5 to 7 nm.

In the case of a high density plasma processing method, the second oxide film 208 is formed on the nitride film 207 by a plasma process using $SiH_4$ or $Si_2H_6$ gas and $O_2$ gas supplied through the gas feed member 15, under conditions similar to those used in the formation of the first silicon oxide film 206 described above.

By doing so, the ONO multi-layered film 230 is formed.

After the steps described above are finished, as shown in FIG. 3D, a second poly-silicon layer 209 is formed on the ONO multi-layered film 230. A metal silicide layer (or metal layer) 210 made of, e.g., WSi is formed on the second poly-silicon layer 209, as needed. Further, an etching stopper layer (not shown) made of, e.g., SiN is formed. Then, patterning and etching are performed by photolithography. At the end, source and drain layers and contact portions (not shown) are formed, so the flash memory device 200 is completed.

Next, an explanation will be given of tests underlying the present invention.

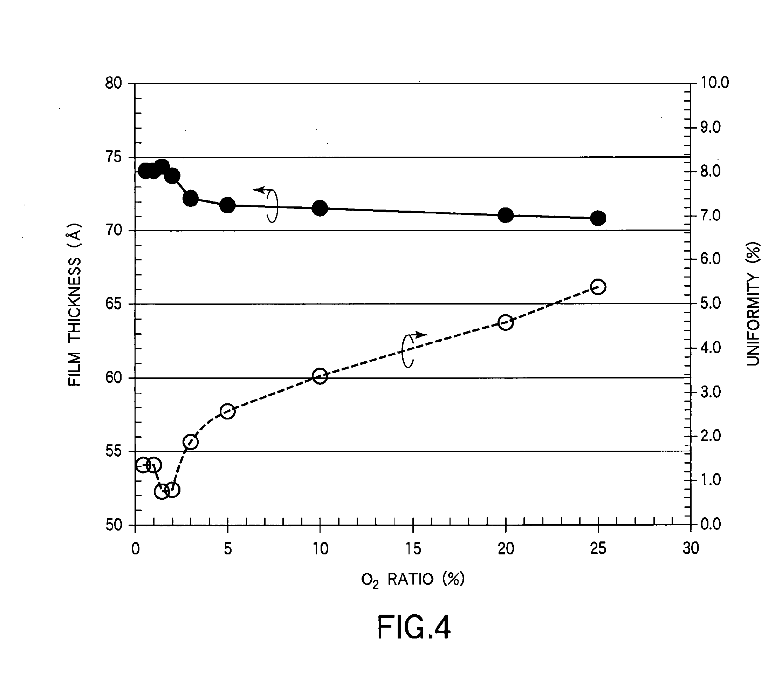

FIG. 4 is a graph showing the relationship between the $O_2$ ratio in a process gas (Ar and $O_2$) and the film thickness and roughness (nonuniformity) of an oxide film, where the oxide film was formed in the plasma processing apparatus 100 shown in FIG. 1. As conditions used for this plasma process, the pressure inside the chamber was set at 133 Pa, the temperature at 500°C, the microwave power at 2,750W, and the process time at 180 seconds. Further, on the condition that the total flow rate became 500 mL/min, the Ar gas flow rate was set at different values within a range of 375 to 495 mL/min and the $O_2$ gas flow rate at different values within a range of 2.5 to 125 mL/min (the oxygen ratio in the process gas was 0.5 to 25% and the oxygen partial pressure was 0.66 to 33.25 Pa).

As shown in FIG. 4, with an increase in the $O_2$ ratio (partial pressure), the oxide film thickness was decreased, i.e., a decrease in the oxidation rate was observed. Further, with an increase in the $O_2$ ratio (partial pressure), the oxide film uniformity was deteriorated.

However, where the $O_2$ ratio in Ar was about 0.5 to 2.5% (the oxygen partial pressure was 1.33 to 2.66 Pa), the film thickness was increased. Where the $O_2$ ratio in Ar was 1 to 2% (the oxygen partial pressure was 1.33 to 1.995 Pa), the film thickness was largest.

Where the $O_2$ ratio was 0.5 to 5%, the film uniformity was also better. In light of the oxidation rate as well, it has been found that the $O_2$ ratio is preferably set to be 0.5 to 5% (the oxygen partial pressure is 0.66 to 6.67 Pa), and more preferably to be 0.5 to 2.5% (the oxygen partial pressure is 0.66 to 2.66 Pa).

Next, a device test pattern was fabricated in accordance with a sequence schematically shown in FIGS. 5A to 5I. An oxide film thus obtained was examined in terms of various electric properties and physical properties.

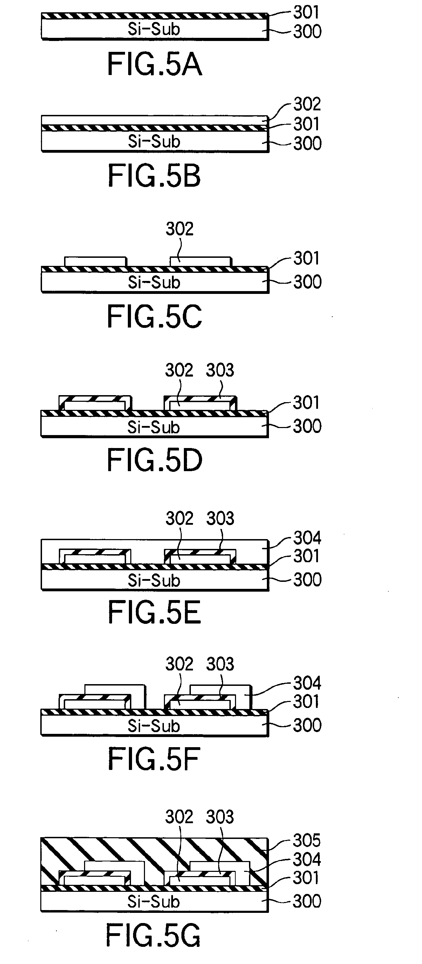

At first, as shown in FIG. 5A, an insulating film 301 was formed to have a film thickness of 100 nm on an Si substrate 300 by thermal CVD. Then, as shown in FIG. 5B, a first poly-silicon layer 302 was formed to have a film thickness of 150 nm on the insulating film 301 by CVD. At this time, the first poly-silicon layer 302 was doped with P at $5 \times 10^{20}$ atom/cm$^3$ and heated at 800°C for 15 minutes to diffuse the P.

Then, a resist film (not shown) was formed on the first poly-silicon layer 302, and, as shown in FIG. 5C, patterning was then performed by photolithography using light exposure, development, etching, and cleaning.

Then, as shown in FIG. 5D, an oxide film 303 was formed by a plasma oxidation process performed on the poly-silicon layer 302 thus etched. This formation of the oxide film 33 was performed by an RLSA plasma oxidation process in the plasma processing apparatus shown in FIG. 1 under conditions in which the pressure inside the chamber was set at 133 Pa, the temperature at 500°C, the microwave power at 2,750W, Ar gas at 500 mL/min, and $O_2$ gas at 5 mL/min. Further, for comparison, an $SiO_2$ film was also formed by each of an HTO (High Temperature Oxidizing)-CVD process and a dry thermal oxidation process. The dry thermal oxidation was performed by $O_2$ dry thermal oxidation at 900°C to obtain an oxide film thickness of 3.5nm. The HTO-CVD was performed by use of $SiH_2Cl_2$ and $N_2O$ at 780°C to form an oxide film.

Then, as shown in FIG. 5E, a second poly-silicon layer 304 was formed to have a film thickness of 1,600 angstroms and to cover the oxide film 303, by an HTO-CVD method. After this second poly-silicon layer 304 was formed, phosphorous was diffused therein at $4 \times 10^{20}$ atom/cm$^3$ by annealing with $POCl_3$.

Then, as shown in FIG. 5F, a resist film (not shown) was formed, and patterning was then performed by photolithography using light exposure, development, etching, and cleaning.

Then, as shown in FIG. 5G, an insulating film 305 was formed by CVD to cover the resultant electrode formed as described above. Further, as shown in FIG. 5H, formation of contact metal 306 was performed by the following method. Specifically, contact holes were formed by photolithography, and were filled with aluminum by sputtering. The aluminum thus provided was then subjected to photolithography using light exposure, development, and etching. After the contact metal formation, an $H_2$ sintering process for the aluminum was performed at 400°C for 30 minutes.

Then, as shown in FIG. 5I, a prober was connected to the resultant gate electrode 310 formed as described above, to measure various electric properties.

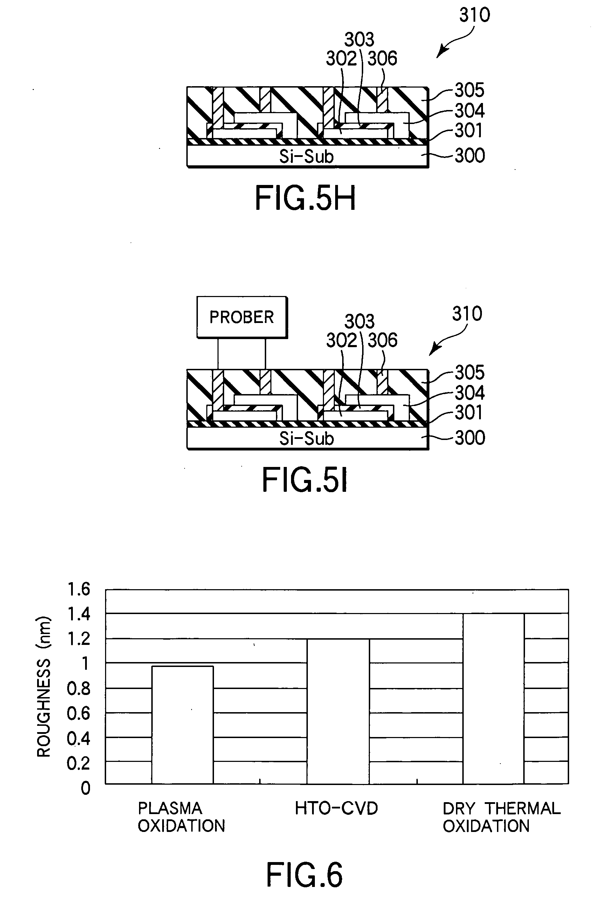

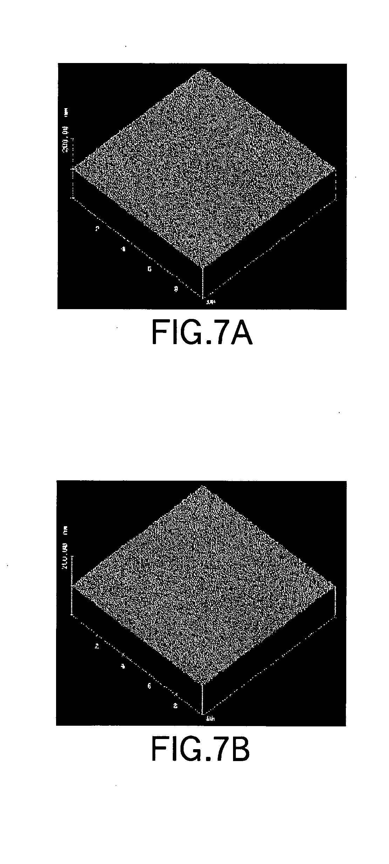

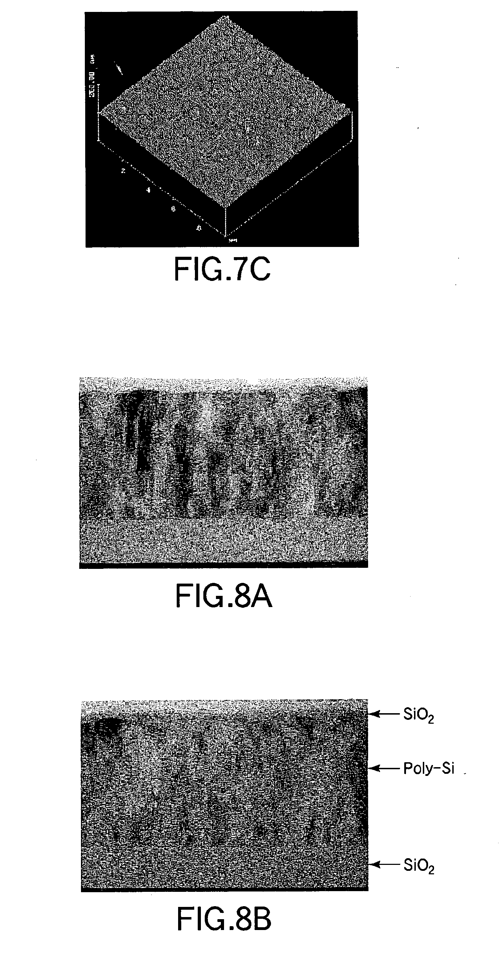

FIG. 6 is a graph showing the surface roughness (roughness) of the first poly-silicon layers 302 for comparison. For this purpose, the oxide film 303 and the layers thereabove in each gate electrode 310 were removed by an HF process, and a surface (10 μm × 10 μm) of the first poly-silicon layer 302 was measured by an AFM (Atomic Force Microscopy). FIGS. 7A to 7C are views each showing a picture image representing a result of this measurement on the surface of the first poly-silicon layer 302. FIG. 7A shows a result obtained by this plasma process according to the present invention. FIG. 7B shows a result obtained by the HTO-CVD process. FIG. 7C shows a result obtained by the dry thermal oxidation process.

As shown in FIGS. 6 and 7A to 7C, the dry thermal oxidation process rendered the largest surface roughness with protrusions formed on the surface of the first poly-silicon layer 302. These protrusions cause the oxide film 303 to have a smaller $SiO_2$ film thickness at their positions, and thus may decrease the breakdown voltage of the film. On the other hand, an improved roughness was obtained by the HTO-CVD process. However, a further improved roughness was obtained by the plasma process performed in the plasma processing apparatus 100 shown in FIG. 1, and thus a dense film of high quality was provided. Further, in this case, unlike the thermal oxidation process, no protrusions were observed on the surface of the first poly-silicon layer 302.

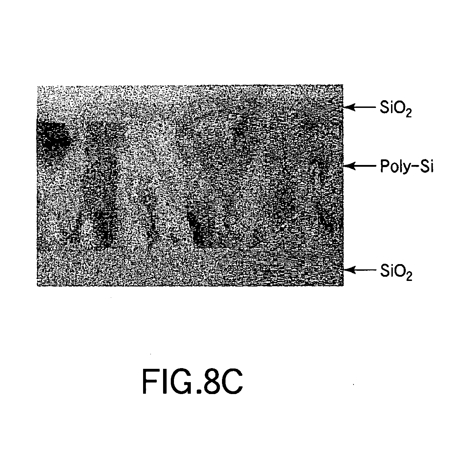

FIGS. 8A to 8C are views each showing a TEM (Transmission Electron Microscope) picture image of a cross-section of the first poly-silicon layer 302. FIG. 8A shows a state before the insulating film 303 was formed (before the oxidation process). FIG. 8B shows a state after the oxidation process according to the present invention was performed in the plasma processing apparatus 100 shown in FIG. 1. FIG. 8C is a state after the thermal oxidation process was performed.

In the case of FIG. 8C, poly-silicon re-crystallization due to a high temperature was noticeably observed in the first poly-silicon layer 302. On the other hand, in the case of the method according to the present invention shown in FIG. 8B, the crystal size and flatness were maintained at levels comparable to those in FIG. 8A showing the state before the process.

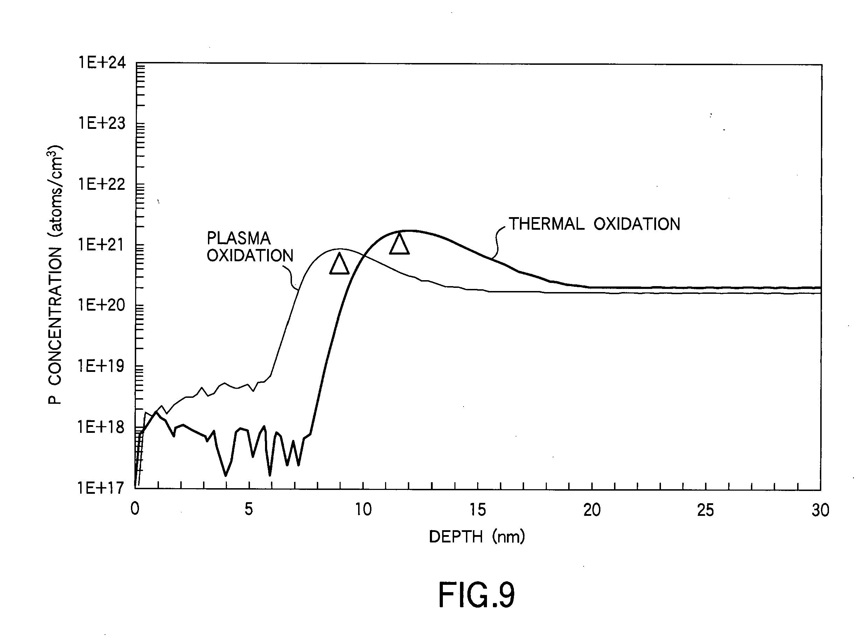

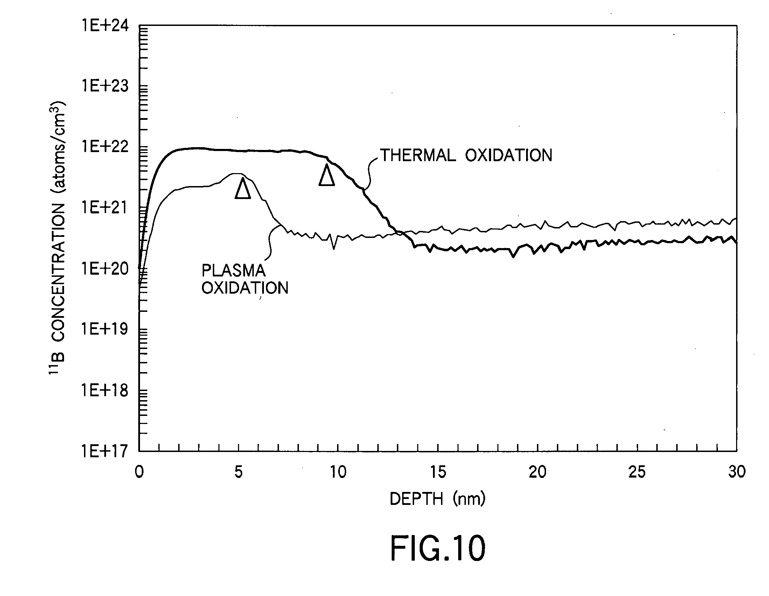

Next, a one-layer oxide film was formed on poly-silicon doped with an impurity to prepare a sample, and the impurity diffusion state thereof was measured. FIG. 9 is a graph showing results of measurement by a SIMS (Secondary Ion Mass Spectrometry) in terms of P (dopant) distribution in the depth direction of a poly-silicon layer doped with P. For this purpose, a poly-silicon layer doped with P was subjected to an RLSA plasma oxidation process to form an oxide film thereon in the plasma processing apparatus 100 shown in FIG. 1, under conditions in which the pressure inside the chamber was set at 133 Pa, the temperature at 500°C, the microwave power at 2,750W, Ar gas at 500 mL/min, and $O_2$ gas at 5 mL/min. Further, for comparison, a poly-silicon layer doped with P was subjected to a thermal oxidation process to oxidize poly-silicon to form an oxide film thereon within an oxygen atmosphere at 1,130°C. FIG. 10 is a graph showing results of measurement by a SIMS in terms of B distribution in the depth direction of a poly-silicon layer doped with B after an oxide film was formed thereon in the same way as described above. In FIGS. 9 and 10, the horizontal axis denotes the depth from the oxide film surface, and triangular symbols denote an interface between the poly-silicon layer and oxide film.

In the case of the thermal oxidation, the P concentration was locally highest near the interface, as shown in FIG. 9, and the B concentration was highest near the interface, as shown in FIG. 10. In this case, diffusion of B into the oxide film was noticeable, and resulted in a change of the B concentration even in the poly-silicon layer. On the other hand, in the case of the plasma process according to the present invention, it was confirmed that an oxide film of high quality was formed because the concentration and re-diffusion of the impurity therein were suppressed.

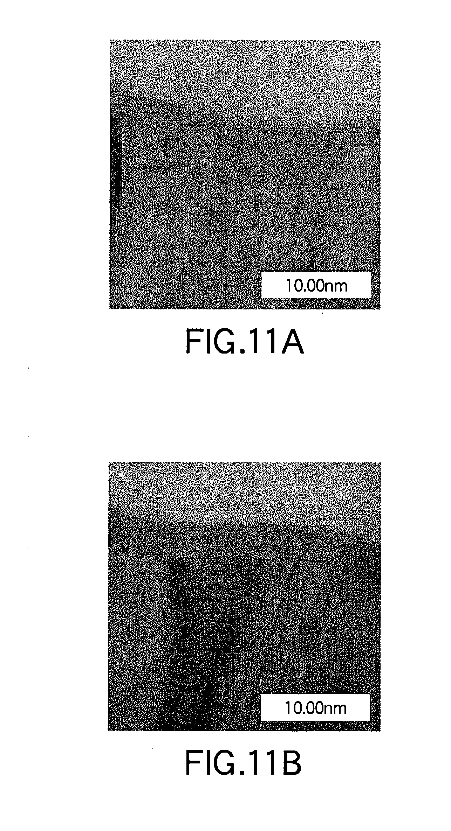

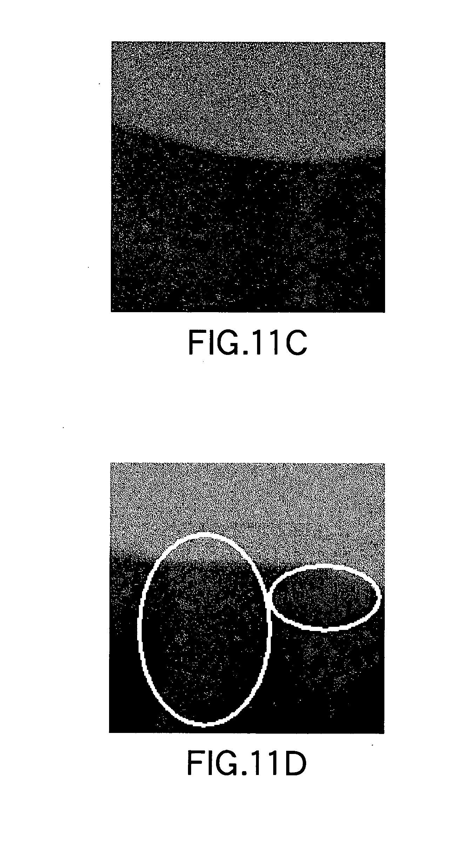

FIGS. 11A to 11D are views each showing a cross-section near the interface between the poly-silicon layer and oxide film ($SiO_2$) of one of the same samples mentioned with reference to FIG. 9. FIGS. 11A and 11B show picture images obtained by a TEM. FIGS. 11C and 11D show picture images obtained by an EELS (Electron Energy Loss Spectroscopy).

As shown in FIGS. 11B and 11D, the thermal oxidation process brought about P segregation, which may serve as a starting point of dielectric breakdown, at the interface between the oxide film and poly-silicon layer. In FIG. 11D, the portions surrounded by circles indicate P segregation regions. On the other hand, as shown in FIGS. 11A and 11C, the oxidation performed in the plasma processing apparatus 100 brought about no P segregation, so the re-diffusion of the dopant was suppressed.

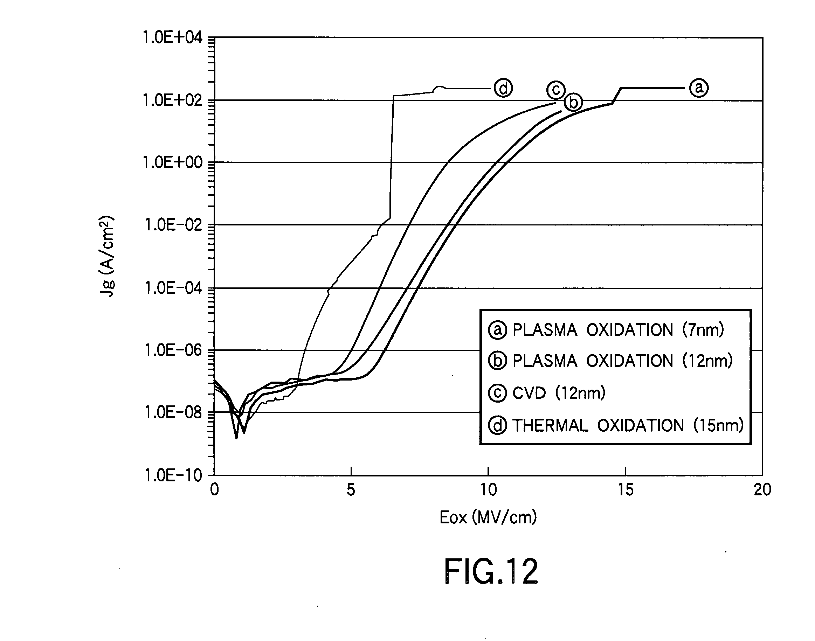

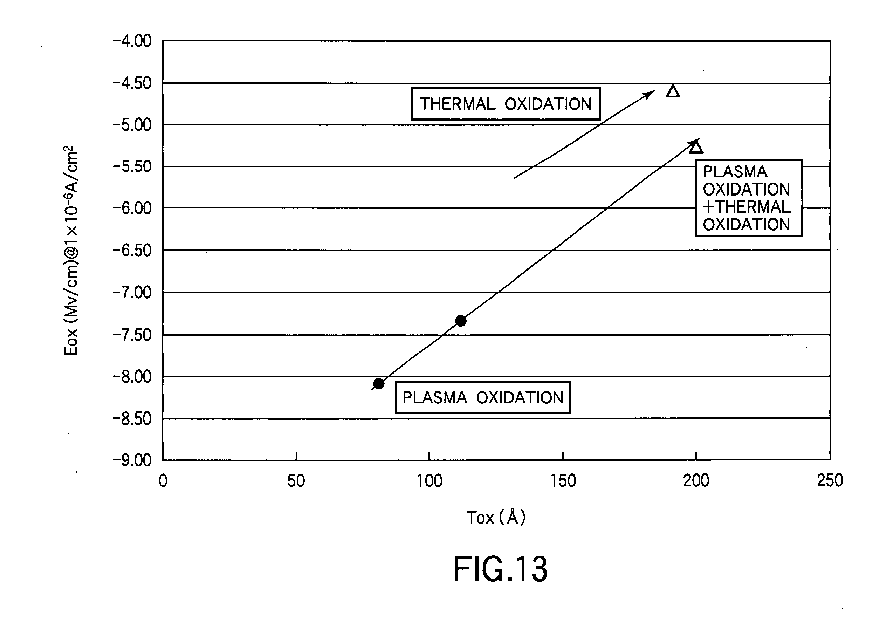

FIGS. 12 and 13 are graphs showing results of examination in terms of dielectric properties of gate electrodes 310 formed in accordance with the sequence shown in FIGS. 5A to 5I.

FIG. 12 is a graph showing J-E plots concerning oxide films formed by a plasma process according to the present invention, HTO-CVD, and dry thermal oxidation, for comparison. In FIG. 12, the vertical axis denotes Jg that represents a leakage current per unit area flowing through the gate oxide film. The horizontal axis denotes Eox that represents a electric field intensity applied to the gate oxide film and is expressed by the following formulas.

$$\text{Eox} = \text{applied voltage/Tox}$$

$$\text{Tox} = (\varepsilon \text{ox} \times \varepsilon 0 \times \text{electrode surface area})/C$$

In the formulas, $\varepsilon$ ox is the dielectric constant of the oxide film, $\varepsilon$ 0 is the dielectric constant of vacuum, and C is value obtained by C-V measurement on the capacity value of the gate oxide film.

The J-E plots show the following cases (a), (b), (c), and (d) for comparison. Specifically, in the case (a), an oxide film was formed to have a film thickness of 7 nm in the plasma processing apparatus 100 shown in FIG. 1. In the case (b), an oxide film was formed to have a film thickness of 12 nm in the plasma processing apparatus 100 shown in FIG. 1. In the case (c), an oxide film was formed to have a film thickness of 12 nm by HTO-CVD. In the case (d), an oxide film was formed to have a film thickness of 15 nm by dry thermal oxidation.

As shown in FIG. 12, the oxide films formed by the oxidation process in the plasma processing apparatus 100 shown in FIG. 1 rendered smaller values of Jg than that of the oxide film formed by the thermal oxidation process. Accordingly, it was confirmed that the former oxide films had a far better breakdown voltage without reference to the film thickness. In other words, even the plasma oxide film of 7 nm was effective to some extent.

FIG. 13 is a graph showing the relationship between the electric field intensity and Tox where the leakage current density was $1 \times 10^{-6}$ [A/cm$^2$]. As shown in FIG. 13, the oxide film formed by the plasma oxidation had a higher breakdown voltage than that of the oxide film formed by the thermal oxidation.

Further, in this test, an additional test pattern (gate electrode) was prepared by use of a modification of the step shown in FIG. 5D. Specifically, in the modification of the step shown in FIG. 5D, an oxide film of 3 nm was first formed in the plasma processing apparatus 100, and a dry thermal oxidation process was then performed within an O$_2$ gas atmosphere at 1,000°C, to form an oxide film having a total thickness of 10 nm. Then, this additional test pattern was subjected to measurement, a result of which was plotted in the graph. From results of this measurement, it was confirmed that the breakdown voltage was improved where thermal oxidation was performed after the plasma oxidation process. This phenomenon is thought to have been resulted from the following mechanism. Specifically, where the initial oxidation stage that tends to have plane direction dependence is performed by plasma oxidation, the surface is prevented from being rough. Consequently, the breakdown voltage of the oxide film is improved even where thermal oxidation is performed thereafter.

Next, the Qbd of a plasma oxide film and a thermal oxide film was measured while a stress of CCS = -0.1 A/cm$^2$ was applied to each of the films. As a result, the Qbd of the thermal oxide film was 0 [C/cm$^2$], and the Qbd of the plasma oxide film was 3.8 [C/cm$^2$]. It was confirmed from this result that the plasma oxide film had very high reliability as compared to the thermal oxide film.

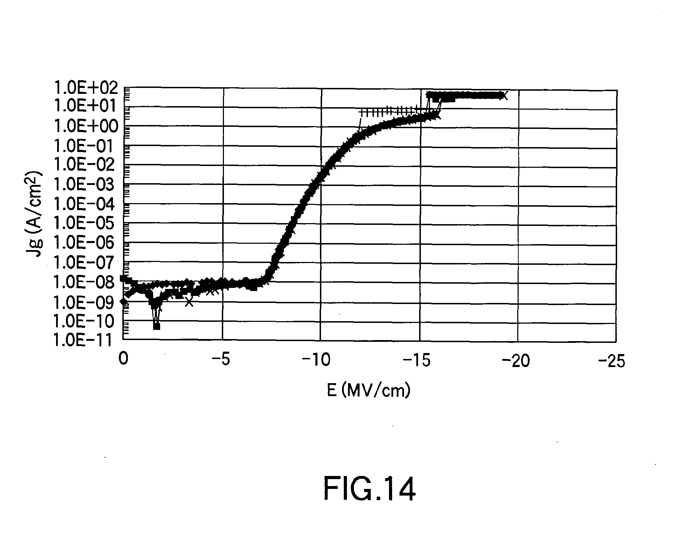

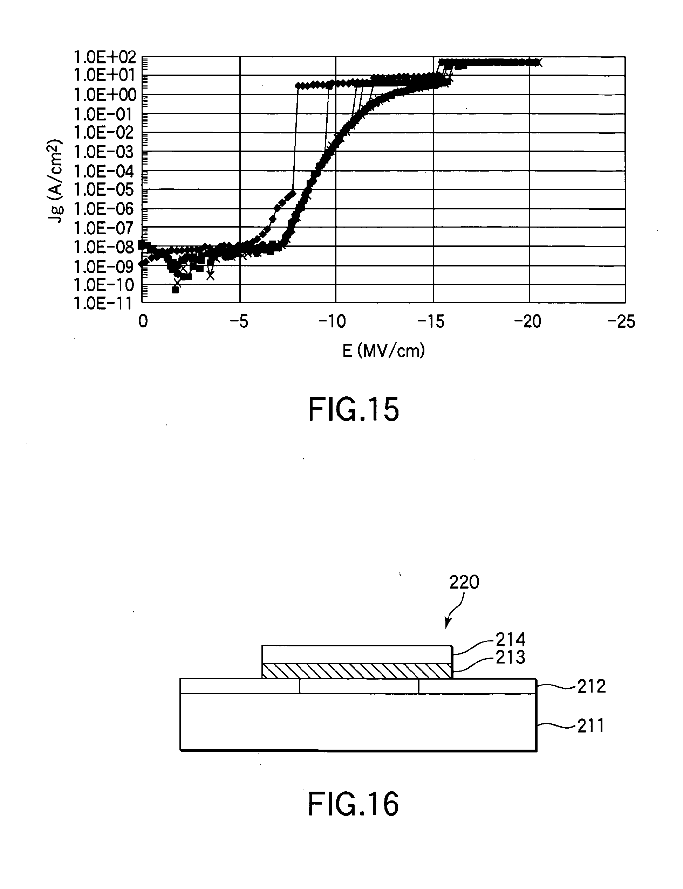

FIGS. 14 and 15 are graphs each showing a J-E plot obtained by examination in terms of the dielectric property of the oxide film 303 of a gate electrode 310 formed in accordance with the sequence shown in FIGS. 5A to 5I.

FIG. 14 shows a J-E plot as a measurement result obtained from the following case. Specifically, an oxide film 303 was formed to have a film thickness of 7 nm by a plasma oxidation process in the plasma processing apparatus 100 shown in FIG. 1, under conditions in which Ar and O$_2$ were supplied at a flow rate ratio of Ar:O$_2$ = 500:5 mL/min (sccm), the process pressure was set at 133.33 Pa, the microwave power at 2,750W, and the process temperature at 500°C.

FIG. 15 shows a J-E plot as a measurement result obtained from the following case. Specifically, an oxide film 303 was formed to have the same film thickness as that described above by a plasma oxidation process in the plasma processing apparatus 100 shown in FIG. 1, under conditions in which Ar, O$_2$, and H$_2$ were supplied at a flow rate ratio of Ar:O$_2$:H$_2$ = 500:5:1 mL/min (sccm), and the process pressure, microwave power, and the process temperature were set at the same values as those described above.

As shown in FIG. 14, where the oxide film 303 was formed by a plasma oxidation process using a process gas containing no hydrogen in the plasma processing apparatus 100 shown in FIG. 1, Jg fluctuations among devices were small, and the breakdown voltage performance was excellent. On the other hand, as shown in FIG. 15, where the oxide film 303 was formed by a plasma oxidation process by use of supply of hydrogen at 1 mL/min (sccm) in addition to Ar and O$_2$, Jg fluctuations among devices were large, and fluctuations in the breakdown voltage performance was also large. This phenomenon is thought to have been resulted from the following mechanism. Specifically, where hydrogen (radicals and/or ions) is present in plasma in the process of forming the oxide film 303, poly-silicon suffers hydrogen damage. Further, if hydrogen is present in the oxide film being formed, the hydrogen separates therefrom and forms hole traps. Consequently, the dielectric property can be unstable. This tendency was particularly prominent where the target object was poly-silicon, as compared to single crystal silicon.

Accordingly, in order to form a silicon oxide film (SiO$_2$) with sufficient dielectric property, it is preferable to exclude hydrogen from the process gas of a plasma oxidation process performed in the plasma processing apparatus 100 shown in FIG. 1. Further, since hydrogen is preferably not present within the process chamber 1 when the plasma oxidation process is performed therein, it is preferable to perform the seasoning described above to remove hydrogen before the plasma oxidation process. Particularly, the seasoning is expected to greatly improve the dielectric property where an oxidation process is performed on poly-silicon to form a silicon oxide film.

The present invention has been described with reference to an embodiment, but the present invention is not limited to the embodiment described above, and it may be modified in various manners.

For example, the embodiment shown in FIGS. 3A to 3D is exemplified by a flash memory device 200. However, an oxide film forming method by plasma oxidation according to the present invention may be preferably applied to a case where the gate oxide film of an ordinary transistor or the gate oxide film of a thin film transistor is formed. For example, FIG. 16 is a view schematically showing a thin film transistor 220, which includes a glass substrate 211 with a first poly-silicon layer 212 formed thereon, and a gate oxide film 213 and a second poly-silicon layer 214 stacked on the first poly-silicon layer 212 in this order. For this thin film transistor 220, when the gate oxide film 213 is formed, a plasma oxidation process may be performed in the plasma processing apparatus 100 while gas flow rates are being controlled. Consequently, an oxide film of high quality can be formed at a high oxidation rate.

In the embodiment described above, a process gas containing Ar and O$_2$ is used to perform an oxidation process, but a process gas containing another gas, such as N$_2$, NO, N$_2$O, NO$_2$, or NH$_3$, may be used. For example, it may be arranged such that an oxynitride film containing nitrogen is first formed at the interface between the poly-silicon and oxide film by a process gas mixed with a gas containing nitrogen, and the oxide film is then formed by thermal oxidation (heating) performed on the resultant structure. By use of this two-stage oxidation process, the number of steps can be decreased. Further, in this case, defects in the oxide film at the interface between the poly-silicon and oxide film are repaired. Consequently, it is possible to improve the reliability of semiconductor devices, while preventing an impurity in the poly-silicon from being diffused into the oxide film.

Further, a silicon oxide film formed according to this embodiment may be further processed such that a silicon nitride film and a thermal oxide film are formed thereon in this order. In this case, the silicon nitride film can be formed in the plasma processing apparatus 100 shown in FIG. 1 by applying plasma of mixture gas of Ar and $N_2$ to the silicon oxide film so as to perform a nitridation process thereon.

Industrial Applicability

The present invention is preferably utilized for manufacturing various semiconductor devices, such as flash memory devices and transistors.

**Claims**

1. An oxide film forming method for a semiconductor device, which includes at least a poly-silicon layer and an oxide film formed on the poly-silicon layer, the method comprising:

   subjecting the poly-silicon layer to a plasma process by use of a process gas containing a rare gas and oxygen gas with a ratio of the oxygen gas relative to the rare gas set to be 0.5 to 5%, thereby forming an oxide film on the poly-silicon layer, within a plasma processing apparatus including a planar antenna with a plurality of slots formed therein, by which microwaves are supplied into a process chamber to generate plasma.

2. The oxide film forming method according to claim 1, wherein the plasma process is performed at a pressure of 67 to 667 Pa and a process temperature of 300 to 600°C.

3. The oxide film forming method according to claim 1 or 2, wherein the process chamber is set to have an oxygen partial pressure of 0.66 to 2.66 Pa therein.

4. A semiconductor device manufacturing method comprising:

   forming an insulating film on a substrate;
   forming a first poly-silicon layer on the insulating film;
   subjecting the first poly-silicon layer to a plasma process by use of a process gas containing a rare gas and oxygen gas with a ratio of the oxygen gas relative to the rare gas set to be 0.5 to 5%, thereby forming an oxide film on the first poly-silicon layer, within a plasma processing apparatus including a planar antenna with a plurality of slots formed therein, by which microwaves are supplied into a process chamber to generate plasma; and
   forming a second poly-silicon layer on or above the oxide film.

5. The semiconductor device manufacturing method according to claim 4, wherein the process chamber is set to have an oxygen partial pressure of 0.66 to 2.66 Pa therein.

6. The semiconductor device manufacturing method according to claim 4 or 5, wherein the semiconductor device comprises a flash memory device or a thin film transistor.

7. An oxide film forming method for a semiconductor device, which includes at least a poly-silicon layer and an oxide film formed on the poly-silicon layer, the method comprising:

   a first oxidation step arranged to subject the poly-silicon layer to a plasma process by use of a process gas containing a rare gas and oxygen gas with a ratio of the oxygen gas relative to the rare gas set to be 0.5 to 5%, thereby forming an oxide film on the poly-silicon layer, within a plasma processing apparatus including a planar antenna with a plurality of slots formed therein, by which microwaves are supplied into a process chamber to generate plasma; and
   a second oxidation step arranged to subject the oxide film formed by the first oxidation step to a thermal oxidation process.

8. The oxide film forming method according to claim 7, wherein the process chamber is set to have an oxygen partial pressure of 0.66 to 2.66 Pa therein.

9. A control program for execution on a computer, used for a plasma processing apparatus including a planar antenna with a plurality of slots formed therein, by which microwaves are supplied into a process chamber to generate plasma, wherein the control program, when executed by the computer, controls the apparatus to subject a poly-silicon layer to a plasma process by use of a process gas containing a rare gas and oxygen gas with a ratio of the oxygen gas relative to the rare gas set to be 0.5 to 5%, thereby forming an oxide film on the poly-silicon layer,

10. A computer storage medium that stores a control program for execution on a computer, used for a plasma processing apparatus including a planar antenna with a plurality of slots formed therein, by which microwaves are supplied into a process chamber to generate plasma, wherein the control program, when executed by the computer, controls the apparatus to subject a poly-silicon layer to a plasma process by use of a process gas containing a rare gas and oxygen gas with a ratio of the oxygen gas relative to the rare gas set to be 0.5 to 5%, thereby forming an oxide film on the poly-silicon layer,

11. A plasma processing apparatus comprising:

a process chamber configured to be vacuum-exhausted and to process a target object by plasma;
a plasma supply source including a planar antenna with a plurality of slots formed therein, by which microwaves are supplied into the process chamber to generate plasma; and
a control section that exercises control to subject a poly-silicon layer to a plasma process by use of a process gas containing a rare gas and oxygen gas with a ratio of the oxygen gas relative to the rare gas set to be 0.5 to 5%, thereby forming an oxide film on the poly-silicon layer within the process chamber.

FIG.1

FIG.2

203

202

201

Si-Sub

**FIG.3A**

205    204

202

201

Si-Sub

**FIG.3B**

230

208   207   206

205    204

202

201

Si-Sub

**FIG.3C**

200

210
208          209
230  207          205
206          204
202

201

Si-Sub

**FIG.3D**

FIG.4

EP 1 786 030 A1

301
Si-Sub
300

FIG.5A

302
301
Si-Sub
300

FIG.5B

302
301
Si-Sub
300

FIG.5C

302 303
301
Si-Sub
300

FIG.5D

302 303
304
301
Si-Sub
300

FIG.5E

302 303
304
301
Si-Sub
300

FIG.5F

302 303
305
304
301
Si-Sub
300

FIG.5G

FIG.5H

FIG.5I

FIG.6

FIG.7A

FIG.7B

FIG.7C

FIG.8A

SiO$_2$

Poly-Si

SiO$_2$

FIG.8B

$SiO_2$

Poly-Si

$SiO_2$

FIG.8C

FIG.9

EP 1 786 030 A1

FIG.10

FIG.11A

FIG.11B

FIG.11C

FIG.11D

FIG.12

EP 1 786 030 A1

FIG.13

EP 1 786 030 A1

FIG.14

FIG.15

FIG.16

<table>
<tr><td colspan="2"><strong>INTERNATIONAL SEARCH REPORT</strong></td><td>International application No.<br>PCT/JP2005/015727</td></tr>
</table>

A.   CLASSIFICATION OF SUBJECT MATTER
**H01L21/316** (2006.01)

According to International Patent Classification (IPC) or to both national classification and IPC

B.   FIELDS SEARCHED

Minimum documentation searched (classification system followed by classification symbols)
**H01L21/316** (2006.01)

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| X<br>A | JP 2001-160555 A  (Tadahiro OMI),<br>12 June, 2001 (12.06.01),<br>Column 4, line 12 to column 5, line 18<br>& US 2002/0014666 A1 | 1-6,9-11<br>7,8 |
| X<br>A | WO 2001/069673 A1  (Tadahiro OMI),<br>20 September, 2001 (20.09.01),<br>Claims<br>& EP 1361605 A1          & US 2004/0142577 A1 | 1-6,9-11<br>7,8 |

☐  Further documents are listed in the continuation of Box C.          ☐  See patent family annex.

| | |
|---|---|
| * Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| | |
|---|---|
| Date of the actual completion of the international search<br>24 November, 2005 (24.11.05) | Date of mailing of the international search report<br>06 December, 2005 (06.12.05) |
| Name and mailing address of the ISA/<br>Japanese Patent Office | Authorized officer |
| Facsimile No. | Telephone No. |

Form PCT/ISA/210 (second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 0169665 A

- WO 0169673 A